# EUROPEAN PATENT APPLICATION

(11) **EP 0 818 820 A1**
(43) Date of publication of application: **14.01.1998**
(21) Application number: 96401538.2
(22) Date of filing: 11.07.1996
(51) Int. Cl.: H01L 23/31

(54) **Full open P-N junction glass passivated silicon semiconductor diode chip and preparation method thereof**

(71) Applicant: Zowie Technology Corp., Hsin-Tien, Taipei (TW)
(72) Inventor: Tai, Chao-Chih, Taipei, Taiwan (TW); Jone, El-Pon, Chiayi City, Taiwan (TW); Tsai, Huei-Jeng, Chiayi City, Taiwan (TW)
(74) Representative: Joly, Jean-Jacques

(57) **Abstract**

In a preparation stage, the whole open P-N junction of the diode is coated with a passivation glass layer. The passivation glass layer is applied to the whole cutting area of each diode chip and fired separately during the preparation procedure. The open P-N junction of the glass passivated silicon semiconductor diode chip has a positive beveled cut, thereby the reverse voltage resistance may be enhanced and the possibility of leakage may be reduced.

## Description

### FIELD OF THE INVENTION

The present invention relates to a full open P-N junction glass passivated silicon semiconductor diode chip and its preparation method, especially to a full open P-N junction glass passivated silicon semiconductor rectifier chip and its preparation method. The preparation method of the present invention includes: preparation of silicon rectifier diode wafer through standard diffusion process, separation of individual diode chips from the silicon rectifier diode wafer, chemical polish and oxidation of the open P-N junction of the diode chips, coating of passivated glass powder on the open P-N junction and sintering of the passivated glass to form a coating glass layer.

### BACKGROUND OF THE INVENTION

In the preparation of silicon semiconductor rectifier diode, the standard diffusion process is widely employed in the industry. The diffusion process as used in the industry includes: diffusion of impurities of pentavalent elements such as phosphorus, arsenic, and impurities of trivalent elements such as boron, aluminum or gallium, respectively on each side of a silicon wafer containing low density of impurities to have a P-N junction in the silicon wafer and a positive and a negative electrode surfaces with lower surface resistance; and formation of metal (such as nickel or aluminum) film with ohmic contact on the surface of the silicon wafer. Different metals are applied according to the desired soldering process that follows. Generally, if soft soldering is the case, nickel and gold may be applied; if hard brazing is the case, aluminum is applied.

After the silicon diode wafer is prepared, the wafer is cut into small dices with a certain shape and size, according to the application purposes of the diodes. The open P-N junction of the chips is then processed by chemical polish to remove the mechanical damages and contamination caused by the separation cutting process. A silicon dioxide film is generated on the silicon diode chip so that the chip may possess good reverse electric properties. Passivation and coating are then applied to the P-N junction of the chip and the chip is thus prepared.

In the conventional art for the preparation of diode chips, three categories of approaches are often used:
I) Subassembly of diode soldered with electric conductive parts:
   Diode wafer is cut into chips. Each of the diode chips is first soldered with electric conductive parts to form a soldered subassembly. Chemical treatment, passivation and coating are then applied to the open P-N junction of the chip. Approaches belonging to this category include: the "Sandwich Cell Construction", as developed by Westinghouse in the early days, and the "Axial Lead Plastic Molded Package" method etc.
II) Glass passivated diode:

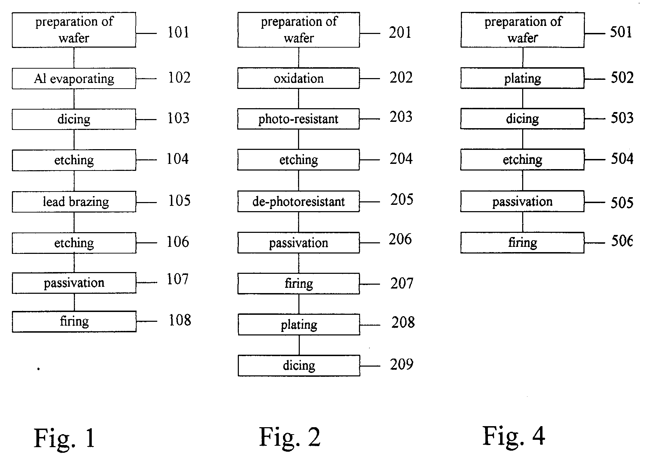

   Fig. 1 illustrates the flow chart of the preparation method of the conventional glass passivated diode. This approach was developed by General Electric Company of USA and was patented. As shown in Fig. 1, at 101 a diode wafer is prepared. At 102 the diode wafer is evaporated with aluminum and at 103 is sandblasted into round beveled chips. At 104 the chips are treated at low temperatures in an etchant with a major component of hydrofluoric acid and nitric acid. The die as polished is brazed at 105 with electric conductive parts on both sides. In the bonding of the electric conductive parts, if hard brazing of aluminum joint is the case where the electrode material has thermal expansion coefficient close to that of silicon, tungsten or molybdenum is usually used. In other cases, brazing materials such as copper-silver-phosphorous alloy is used in the bonding of the electrodes to the copper lead wire. A second chemical treatment is applied to the open P-N junction of the chip of the brazed subassembly 106. At 107 passivation glass is coated and, at 108, fired into a vitrified coating layer. This approach is a relatively progressive one in the preparation of diode chips.
III) Groove open P-N junction glass passivated diode:

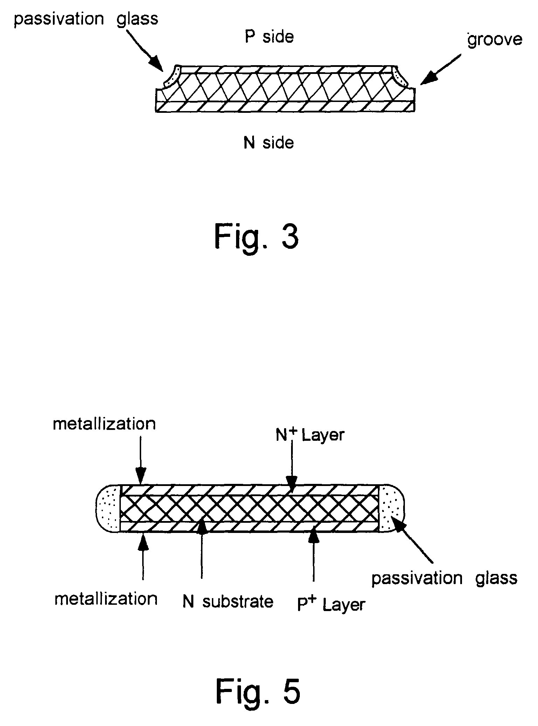

   Fig. 2 illustrates the flow chart of the preparation method for the groove open P-N junction glass passivated diode. As shown in the figure, at 201 a diode wafer is prepared according to the conventional art. At 202 the diode wafer is oxidized and at 203 is coated with a photoresistant agent. At 204 standard lithographic technique and etching are applied to form grooves at the P side of the diode wafer. The grooves surround the edges of the diode chips to be separated. The pattern and the depth of the groove are in such a way that each diode chip has its P-N junction exposed but a part of its base layer and the N+ layer remain connected. At 205 the photoresistant agent is removed and at 206 the grooved wafer is applied with passivation glass in the grooves. At 207 the passivation glass is fired. At 208 metal films are plated on the wafer to make electrodes. At 209 chips are cut from the wafer. Rectified chips prepared through this approach are called GPP, or glass passivated pellets. Fig. 3 shows the structure of a silicon semiconductor diode chip prepared under the GPP approach.

Among the conventional arts, the GPP approach is more welcome than the other approaches and thus is widely employed in the industry in the manufacturing of diode modules such as rectifier circuit modules. A good example of the component manufactured by this approach is the bridge rectifier. In addition, GPP is also applicable to small outline diodes (SOD).

The GPP, however, has several drawbacks. For example, GPP has a negative beveled cut on the P-N junction. This is because during the preparation process, grooves are etched at the P side of the wafer. Due to this structure, a depletion region developed under reverse voltage bias will cause a reverse electric field extending to the P-N junction in the groove cutting contour. To solve this problem, a larger area is then required so that the loaded power may be equal to diode chips prepared under the "vertical cut approach" or the "positive beveled cut approach". Manufacturing costs of diode chips are thus increased. To be more concrete, for example, in a rectangular diode chip of 1 ampere prepared under the GPP approach, the surface area in the P side is about 0.96 mm x 0.96 mm (38 mil x 38 mil) and in the N side is about 1.4 mm x 1.4 mm (55 mil x 55 mil). The effective area ratio of the chip is 0.96 mm x 0.96 mm/1.4 mm x 1.4 mm (38 mil x 38 mil/55 mil x 55 mil), about 47 %. Another drawback of GPP is the fact that higher reverse voltage resistance is not easy to obtain under this approach.

Nevertheless, the GPP approach includes a plurality of lithographic processes. This is because when the glass passivation material is applied to the grooves, the cutting line of the grooves shall be protected with, for example, photoresistants. In the plating of the metal films, the grooves shall be covered with, again, photoresistants. As a result, manufacture under GPP process requires expensive equipment and processes.

Last but not least, the last stage of GPP approach is the separation of the chips. Mechanical damages to the glass coating are inevitable during the cutting process. Cracks formed on the glass coating cause stress concentration which becomes an important source of operation failure.

There is thus an urgent need in the industry to have a novel structure of a silicon semiconductor diode chip and a new method to prepare the diode chip which overcome the problems of the GPP approach.

### OBJECTS OF THE INVENTION

The object of the present invention is to provide a novel preparation method of silicon semiconductor diode chips wherein the full open P-N junction of the semiconductor diode chips is coated with passivation glass.

Another object of the invention is to provide a method for the preparation of silicon semiconductor diode chips whereby the area occupied by a semiconductor diode chips may be reduced.

Another object of this invention is to provide a simplified preparation method for silicon semiconductor diode chips in which the full open P-N junction of the semiconductor chips is sealed; thereby improved electric characteristics are obtained.

Another object of this invention is to provide a simplified preparation method of silicon semiconductor chips whereby the diode chips so prepared possess higher peak reverse voltage.

Another object of this invention is to provide a full open P-N junction glass passivated silicon semiconductor diode chip which may be manufactured in large quantity with simplified process and equipment.

### SUMMARY OF THE INVENTION

According to the present invention, a full open P-N junction glass passivated silicon semiconductor diode chip and its preparation method are disclosed wherein the full open P-N junction of the semiconductor diode chip is coated with passivation glass. A glass passivation layer is prepared on each single piece of the semiconductor diode chip and is fired separately. Damages to the glass passivation layer during the cutting process in the GPP approach may be avoided.

The full open P-N junction glass passivated silicon semiconductor diode chip of this invention has a positive beveled cut at the open P-N junction; the peak reverse voltage being enhanced and the possibility of leakage reduced.

The above and other objects and advantages of this invention may be more clearly understood from the following description by referring to the drawings.

### BRIEF DESCRIPTION OF THE DRAWINGS

In the figures,
Fig. 1 illustrates a flow chart of the preparation method of the conventional glass passivated diode.
Fig. 2 illustrates a flow chart of the preparation method for a groove open P-N junction glass passivated diode.
Fig. 3 illustrates the structure of a silicon semiconductor diode chip prepared under the GPP approach.
Fig. 4 illustrates a flow chart of the preparation method of the full open P-N junction glass passivated silicon semiconductor diode chip of this invention.
Fig. 5 illustrates the structure of the full open P-N Junction glass passivated silicon semiconductor diode chip of this invention.
Fig. 6 is a photomicrograph of a semiconductor diode chip according to an embodiment of the present invention.

Table I shows the reverse electric properties of the diode chips prepared according to the method of this invention.

### DETAILED DESCRIPTION OF THE INVENTION

In order to prepare the full open P-N junction glass passivated silicon semiconductor diode chip of this invention, a silicon semiconductor diode wafer is prepared under applicable conventional technology. Silicon semiconductor wafer is treated with diffusion. A metallized film is evaporated on both the negative and the positive sides of the wafer. The wafer is then cut into small chips (dice) with a exposed, open P-N junction.

According to the present invention, the diode chips so prepared are processed with chemical polish and oxidation; application of passivation glass on the full open P-N junction; and firing of the passivation glass to form a vitrified layer over the full open P-N junction on each chip.

If necessary, the chips so prepared may be plated with a metal film on the P- or N-side. Applicable materials for the metal film include: aluminum, nickel or silver, or gold plated.

Fig. 4 illustrates a flow chart of the method of the preparation of full open P-N junction glass passivated silicon semiconductor diode chips of this invention. The following are descriptions of the processes of the invented method.

At 501 a diode wafer is diffused to have a P-N junction. At 502 the diode wafer is plated with metals on both sides as electrodes. The electrodes may be evaporated aluminum, nickel, silver or gold plated. The selection of the materials of the electrodes is made according to the application of the chip.

At 503 the metalized wafer is sand blasted or chemically etched into dice in a mesa shape. If the wafer is blasted from the N side, the open P-N junction will naturally have a positive beveled cut. The dice may be of round mesa shape, round-angled rectangular mesa shape, round-angled hexagon mesa shape or other suited shapes. The P electrode side is at the bottom of the mesa shape.

At 504 the dice are treated with chemical polish and oxidation agents. If the dices are aluminum evaporated, they are generally treated in an agent of a composition of hydrofluoric acid and nitric acid to etch off cutting damages and to form a silicon dioxide film. If the dices are plated with nickel, silver or gold plated, they are treated in a solution of potassium hydroxide. Either of these approaches results satisfactory characters.

The chips are positioned in a fixture and the full open P-N junction is applied with paste of passivation glass powder at 505. At 506 the passivation glass is dried and fired to form a vitrified layer. The full open P-N junction glass passivated silicon semiconductor diode chip of this invention is thus accomplished.

According to this invention, the full open P-N junction of the dice is coated with passivation glass. A glass sealing layer is prepared on each single diode chip. In the embodiments of this invention, the passivation glass applied to the open P-N junction may be composed paste of passivation glass powder and water or other vehicle agent, or other suited materials.

In one embodiment of this invention, the electrodes are not plated to a wafer before it is blasted into dice, but are plated to the dice after they are passivated with glass.

Fig. 5 shows the structure of a full open P-N junction glass passivated silicon semiconductor diode chip prepared under the method of this invention. As shown in the figure, the full open P-N junction of the diode chip is sealed with a layer of passivation glass and each chip is treated as a single part.

Chips as prepared from such processes may be tested, classified and packaged according to industrialized specifications. The outline of the chips may be round, round mesa, round-angled rectangular, round-angled hexagon mesa or other applicable shapes.

### EMBODIMENTS

### EMBODIMENT 1: Diode chips pasted with glass passivation layer.

A wafer metalized with evaporated aluminum is sand blasted in to round mesa shaped dices with 50mil diameter with N side at top of the mesa. The chips are treated in a solution of nitric acid, hydrofluoric acid and acetic acid to etch off sandblasting damages and to form silicon oxide over the cutting area.

Chips are positioned in a fixture and the open P-N junction is applied with passivation glass slurry. The chips are then dried and fired in an electric furnace to melt the glass powder and form a vitrified coating over the full open P-N junction of the diode chip.

Applicable fixture of this embodiment includes a positioning plate with a plurality of positioning vacuum holes and a shaping plate with a plurality of shaping holes. The diameter of the positioning vacuum holes is smaller than that of the diode chips. Each positioning vacuum hole is connected through vacuum chamber to a vacuum pump so that a diode chip may be positioned at the positioning hole.

The height of the shaping plate is approximately equal to that of the die. The diameter of the shaping holes is larger than that of the diode chip. The positions of the shaping holes correspond to those of the positioning holes. The positioning plate and shaping plate are laminated to serve as a fixture for applying glass slurry over the edges of the diode chips.

Diode chips to be processed are positioned in a conventional vacuum dice loader. The vacuum dice loader is vibrated so that the chips are positioned inside the positioning holes of the vacuum dice loader. The chips are removed from the vacuum dice loader to the fixture, inside the position and shaping holes.

Passivation glass slurry is prepared with a paste vehicle and is applied into the space between the dice and the wall of the positioning-shaping holes with a blade. The glass slurry on the surfaces of the chips is then cleaned. The full open P-N junction of the diode chips is coated with the glass slurry.

Next, the shaping plate is removed. The diode chips are positioned at the positioning holes of the positioning plate. The glass slurry is dried. A firing plate is covered over the diode chips. The positioning plate is turned around and the diode chips are removed from the positioning plate with knock-out pins. The diode chips with the full open P-N junction coated with passivation glass are positioned on the firing plate. The diode chips are then fired so that the glass coating forms a vitrified layer.

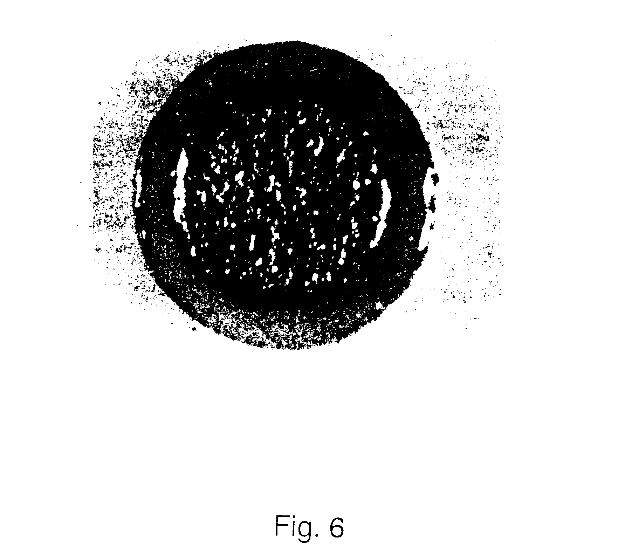

The outer surface of the open P-N junction of the chip so prepared is coated with a passivation glass film. Observation under microscope reveals that no mechanical damage, breaks or cracks may be found on the chips. An attached photograph (Figure 6) shows a full open P-N junction glass passivated silicon semiconductor diode chip prepared under this embodiment, as enlarged by 40 times.

It is obvious that the full open P-N junction glass passivated silicon semiconductor diode chip of this invention possesses excellent properties.

### EMBODIMENT 2: Diode chips processed with stencil plate - squeeze approach

A diode wafer not metalized is prepared according to the conventional art. The P side and the N side are coated with etching resists.

The wafer is then separated with a dicing saw to have hexagon dices. The cutting area of the dice from the N-side to the P-side, including the P-N junction is exposed to the open air. The chips are treated in an etchant of nitric acid and hydrofluoric acid as major component to etch off damage and to form silicon dioxide over the exposed area.

Chips are positioned in a fixture and the whole cutting area including the P-N junction is applied with passivation glass slurry. In this embodiment, the passivation glass is squeezed to the cutting area of the chips with a stencil plate. The chips are then dried and fired to de-bind and melt the glass powder and to form a vitrified coating over the full open P-N junction of the diode chip.

An applicable fixture of this embodiment includes a ceramic loading plate pasted with positioning adhesives and a stencil plate with a plurality of shaping holes. Applicable adhesives include any material which may be burned off under 500°C atmosphere. This includes ethyl cellulose solutes in n-butyl carbitol.

The stencil plate is a planar plate with a plurality of shaping holes. The thickness of the stencil plate is about the same as that of the diode chips. The distribution of the shaping holes on the stencil plate corresponds to the distribution of the diode chips on the ceramic plate. The ceramic plate and the stencil plate are laminated, to serve in combination as a set of glass slurry application tools for the diode chips.

Diode chips to be processed are positioned in a conventional vacuum dice loader. The vacuum dice loader is vibrated so that the chips are positioned inside the positioning holes of the vacuum dice loader. The chips are removed from the vacuum dice loader to the ceramic plate and adhered to the ceramic plate by a burn-off type adhesive printed thereon in advance. The stencil plate is then laminated, overlapping the ceramic plate, so that the dices are positioned inside the shaping holes.

Passivated glass slurry is prepared with a paste vehicle and is applied into the space between the dice and the wall of the shaping holes with a blade. The glass slurry on the surfaces of the dice is cleaned off. The full open P-N junction of the diode chips is coated with the glass slurry. Materials for the passivation glass include PbO₂, SiO₂ and B₂O₃. Some commercialized thick film slurry such as IP-900 are also applicable in this invention.

The stencil plate is removed. The diode chips applied with the passivation glass are positioned on the ceramic loading plate. The glass slurry is dried and fired to burn off the binder and to form a vitrified layer.

If necessary, a nickel or gold film is plated over the P- or N- side of the diode chips adopting the conventional arts.

The entire contour surfaces of the open P-N junction of the chip so prepared is coated with a passivation glass film. Observation under microscope reveals that no mechanical damage, breaks or cracks may be found on the chips.

### EMBODIMENT 3: Diode chips mold-injected with passivation glass.

Hexagon diode chips are obtained according to the method of Embodiment 2. The chips are positioned and adhered to a plate and the open P-N junction is applied with passivation glass coating by way of injection molding. The chips are then unbound and fired to form a vitrified coating over the full open P-N junction.

Passivation glass injection molding compound is prepared by adding a thermal plastic binder to the glass powder. Applicable materials of the plastic binder include those that may be burned off under 500°C atmosphere. Examples are LDPE, stearic acid and paraffin wax.

Diode chips to be processed are positioned in a conventional vacuum dice loader. The vacuum dice loader is vibrated so that the chips are positioned inside the positioning cavities of the vacuum dice loader. The chips are removed from the vacuum loader to a positioning plate and are adhered by pre-printed adhesives.

The dice holding plate is positioned into an injection mold. Passivation glass compound is injected into the cavities, forming a cast element over the edge surface of each die.

The diode chips are then fired to burn off the binder and to form a vitrified layer.

If necessary, a nickel or gold film is plated to the P-side or N-side of the diode chip by conventional art.

Observation under microscope reveals that no mechanical damages, breaks or cracks may be found in the glass element.

Table I records the reverse electric properties of the diode chips prepared according to the method of this invention. As the measurement shows, all examples possess reverse voltage resistance higher than 1,200 volt. The average reverse voltage resistance is 1,400 volt.

**Table I**

| Sample No. | Reverse Voltage | Sample No. | Reverse Voltage |
|---|---|---|---|
| 1 | 1200 | 11 | 1450 |
| 2 | 1450 | 12 | 1250 |
| 3 | 1600 | 13 | 1450 |
| 4 | 1600 | 14 | 1300 |
| 5 | 1250 | 15 | 1400 |
| 6 | 1400 | 16 | 1600 |
| 7 | 1450 | 17 | 1300 |
| 8 | 1450 | 18 | 1450 |
| 9 | 1300 | 19 | 1200 |
| 10 | 1800 | 20 | 1850 |

### EFFECTS OF THE INVENTION

According to the present invention, the open P-N junction of the diode chips is coated with passivation glass. As each chip is treated independently, mechanical damages and cracks may be avoided.

The full open P-N junction glass passivated silicon semiconductor diode chip of this invention may be mass manufactured from simple and low-cost equipment, enabling low cost, simplified process, variety of metalized electrode surface and enhanced properties.

As the open P-N junction of the die so prepared has a positive beveled cut, its peak reverse voltage may be increased and its reverse leakage may be reduced.

The chips as prepared according to the method of this invention have a smooth glass surface and are applicable to manufacture processes such as automatic feeding and fixture emplacement.

The chip assembly and the method of this invention may be applicable to a variety of rectifiers and rectifier circuit modules such as a bridge rectifier. This invention is also suited for the preparation of small outline diodes (SOD) rectifiers.

As the invention has been shown and described with reference to preferred embodiments thereof, those skilled in the art will recognize that the above and other changes may be made therein without departing from the scope of the invention.

## Claims

1. A semiconductor diode chip assembly comprising:
a silicon semiconductor diode chip; and
a passivation glass coating;
characterized in that the edge circulating said diode chip has a cutting plane from its P-side to its N-side including its P-N junction and that a passivation glass layer is coated on the whole cutting plane of the circulating edge of said diode chip.

2. The semiconductor diode chip assembly of claim 1 wherein the outline of the diode chip is round, round mesa, round-angled rectangular, round-angled hexagon mesa or other applicable shapes.

3. The semiconductor diode chip assembly of claim 1 wherein the included angle of the cutting plane and the N-side surface is approximately 90 degrees.

4. The semiconductor diode chip assembly of claim 1 further comprising a metal film on its P-side surface and a metal film on its N-side surface.

5. The semiconductor diode chip assembly of claim 4 wherein the metal film on the P- or N-side is selected from evaporated aluminum, nickel-silver plated, or nickel-gold plated.

6. A method for the preparation of a semiconductor diode chip including:
preparation of a semiconductor diode chip with its cutting plane from its N-side to its P-side including the P-N junction exposed to the open air:
chemical polish and oxidation of the full P-N junction;
applying a passivation glass layer over the open P-N junction of said diode chip; and
heating of the passivation glass to have a vitreous coating layer on the diode chip;
characterized in that said passivation glass layer is applied on the whole cutting plane of the diode chip, including the P-N junction.

7. The method of Claim 6 wherein the outline of said diode chip is round mesa shape, round-angled rectangular mesa shape or round-angled hexagon mesa shape.

8. The method of claim 6 wherein the included angle of the cutting plane and the N-side surface is approximately 90 degrees.

9. The method of claim 6 further comprising plating of a metal film on the P-side and on the N-side of the diode chip.

10. The method of Claim 6 wherein said metalized film is evaporated aluminum, nickel-silver plated, or nickel-gold plated.

11. The method according to any one of Claims 6 to 10 wherein the process of applying said passivation glass includes:
positioning the diode chip in a fixture comprising a positioning plate with a plurality of positioning means and a shaping plate with a plurality of shaping holes wherein the diameter of the shaping holes is slightly grater than that of the chip;
applying a passivation glass into the space between the chip and the wall of the shaping hole; and
removal of said shaping plate whereby the chip is positioned on said positioning plate.

12. The method according to Claim 11 wherein the positioning means of the positioning plate comprises a suction pipe to be connected to a vacuum compressor and a plurality of suction inlets wherein the diameter of the suction inlets is slightly smaller than that of the diode chips.

13. The method according to Claim 11 further comprising removing the diode chip to a firming plate.

14. The method according to any one of Claims 6 to 10 wherein the process of applying said passivation glass includes:
positioning the diode chip on a loader with an adhesive; and
applying a passivation glass on the cutting plane of the circulating edge of the chip.

15. The method according to Claim 14 wherein the process of applying the passivation glass layer includes:
mounting a stencil plate on said loader plate wherein said stencil plate is comprised of a plurality of positioning holes, wherein the diameter of said positioning holes is slightly greater than that of the diode chip;
applying the passivation glass into the space between the diode chip and the wall of the positioning hole; and
removal of the stencil plate whereby the diode chip is positioned on the loader plate.

16. The method according to Claim 11 further comprising scraping off the glass on the surface of the diode chip other than that on the cutting plane of the diode chip.

17. The method according to Claim 14 wherein the passivation glass is applied on the cutting plane by injection.

18. The method according to Claim 17 further comprising burning off said adhesives.

19. The method according to Claim 17 further comprising forming a nickel or gold film on the P- or N- side of the diode chip by chemical plating.
